# DEMANDE DE BREVET EUROPEEN

(11) **EP 1 061 581 A1**
(43) Date de publication de la demande: **20.12.2000**
(21) Numéro de dépôt: 00410056.6
(22) Date de dépôt: 13.06.2000
(51) Int. Cl.: H01L 27/02

(54) **Circuit de protection et de filtrage**

(30) Priorité: 15.06.1999 FR 9907860
(71) Demandeur: STMicroelectronics S.A., 94250 Gentilly (FR)
(72) Inventeur: Berthiot, Denis, 37000 Tours (FR)
(74) Mandataire: de Beaumont, Michel

(57) **Abrégé**

L'invention concerne un composant monolithique constituant une structure de protection contre des décharges électrostatiques et de filtrage comprenant, du côté de la face supérieure d'un substrat (30) d'un premier type de conductivité, une région (31) du type de conductivité opposé séparée en trois zones principales recouvertes de métallisations respectives (M12, M13, M14), la face arrière du composant étant revêtue d'une métallisation (M11).

## Description

La présente invention concerne la réalisation d'un circuit pouvant avoir à la fois une fonction de protection contre des surcharges et une fonction de filtrage.

Un tel circuit est décrit dans la demande de brevet européen EP-A-0905852 de la demanderesse (B3711).

La figure 1 ci-jointe reproduit la figure 4C de cette demande de brevet et représente un circuit particulier de filtre et de protection. Ce circuit comprend entre deux bornes d'entrée 11 et 12 une première diode Zener Z1, et entre deux bornes de sortie 13 et 14 une deuxième diode Zener Z2. La deuxième borne d'entrée 12 et la deuxième borne de sortie 14 sont confondues. Elles sont connectées par un condensateur C1 au point milieu de deux résistances R1 et R2 dont les autres bornes sont respectivement connectées à la borne d'entrée 11 et à la borne de sortie 13.

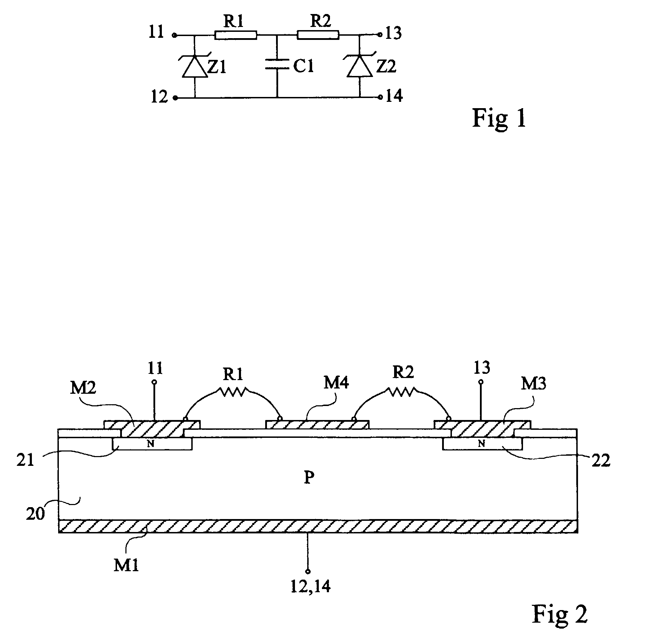

En outre, la demande de brevet susmentionnée décrit en relation avec sa figure 5, qui est reproduite dans la figure 2 ci-jointe, une réalisation monolithique du circuit de la figure 1. La structure est formée dans un substrat 20 de type P. La diode Zener Z1 est formée verticalement entre une région 21 et le substrat 20. La diode Zener Z2 est formée verticalement entre une région de type N 22 et le substrat 20. Le condensateur C1 est formé entre une métallisation M4 et le substrat 20, la métallisation M4 étant séparée du substrat par une couche isolante constituant le diélectrique du condensateur. Il est indiqué que les résistances R1 et R2 peuvent être réalisées de diverses manières. Une métallisation M1 recouvre la face arrière et est connectée aux bornes 12, 14. Une métallisation M2 recouvre la région 21 et est connectée à la borne 11. Une métallisation M3 recouvre la région 22 et est connectée à la borne 13. La métallisation M4 est connectée aux résistances R1 et R2.

Comme cela a été indiqué précédemment, le circuit de la figure 1 présente la caractéristique d'avoir deux fréquences de coupure respectivement fixées par la capacité du condensateur C1 et celle des diodes Zener Z1 et Z2.

Toutefois, la réalisation illustrée en figure 2 présente plusieurs inconvénients. Elle est relativement complexe à mettre en oeuvre. Elle nécessite un ajustement précis du diélectrique du condensateur. Comme ce diélectrique ne peut être rendu trop mince, le condensateur a une surface relativement élevée. De plus, les capacités des diodes Zener et du condensateur à diélectrique dérivent en fonction de la température de façon distincte.

La présente invention vise à réaliser sous forme monolithique un composant mettant un oeuvre le circuit de la figure 1 et palliant un ou plusieurs des inconvénients de la structure de la figure 2.

Pour atteindre cet objet, la présente invention prévoit un composant monolithique constituant une structure de protection contre des décharges électrostatiques et de filtrage comprenant, du côté de la face supérieure d'un substrat d'un premier type de conductivité, une région du type de conductivité opposé séparée en trois zones principales recouvertes de métallisations respectives, la face arrière du composant étant revêtue d'une métallisation. L'une des zones principales est reliée à chacune des autres zones par une portion de la région du type de conductivité opposé de surface réduite.

Selon un mode de réalisation de la présente invention, les zones situées sous les première et deuxième métallisations ont de mêmes surfaces.

Selon un mode de réalisation de la présente invention, le substrat est une région de type P d'un niveau de dopage de l'ordre de 10¹⁸ atomes/cm³ et la région du type de conductivité opposé est une région de type N d'un niveau de dopage de l'ordre de 10²⁰ atomes/cm³.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1 et 2 représentent respectivement un circuit électrique de protection et de filtrage et un exemple de réalisation monolithique de ce circuit, et correspondent respectivement aux figures 4C et 5 de la demande de brevet européen EP-A-0905852 ; et
Les figures 3A et 3B représentent respectivement une vue de dessus et une vue en coupe selon une ligne B-B d'un mode de réalisation monolithique du circuit de la figure 1.

Le composant selon l'invention est constitué à partir d'un substrat 30 de type P qui comprend du côté de sa face avant une région 31 du type de conductivité opposé. Du côté de la face arrière est formée une métallisation M11, avec de préférence interposition d'une région de type P plus fortement dopée 32. Du côté de la face avant sont formées des métallisations respectives M12, M13 et M14 en contact avec des zones de la région 31. Plus particulièrement, la métallisation M12 est constituée au-dessus d'une zone correspondant sensiblement à la diode Zener Z1 ; la métallisation M13 est formée au-dessus d'une zone correspondant sensiblement à la diode Zener Z2 ; et la métallisation M14 est disposée au-dessus d'une zone correspondant sensiblement au condensateur C1.

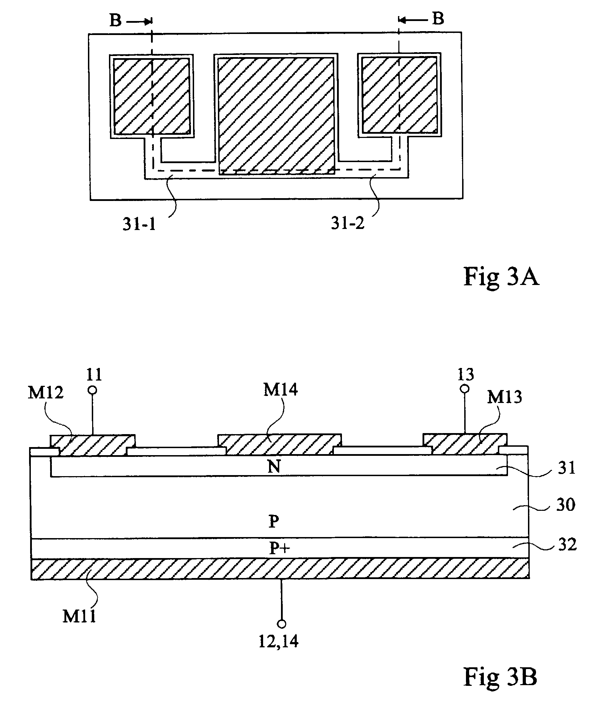

Comme cela est illustré plus particulièrement en figure 3A, la région diffusée 31 comprend de préférence des portions 31-1 et 31-2 non recouvertes de métallisation qui s'étendent entre la zone recouverte de la métallisation M14 et, respectivement, la zone recouverte de la métallisation M12 et la zone recouverte de la métallisation M13. Les portions 31-1 et 31-2 correspondent respectivement aux résistances R1 et R2.

Bien que l'on ait indiqué ci-dessus que chacun des composants est situé sous chacune des métallisations, il sera clair pour l'homme de l'art qu'en fait, le condensateur C1 est relativement réparti et s'étend au-delà de la zone située immédiatement en dessous de la métallisation M14, dans les prolongements correspondant aux portions 31-1 et 31-2. On notera également que l'on peut considérer la zone située sous la métallisation M14 comme une diode Zener ou comme un condensateur mais que dans le fonctionnement envisagé, cette zone se comporte en fait comme un condensateur qui a la particularité d'être "autoprotégé" contre des décharges électrostatiques.

Dans un exemple de réalisation, on choisira pour le substrat P un niveau de dopage de quelques 10¹⁸ at./cm³ (résistivité de l'ordre de 10 milliohms/cm). Pour la région N, on choisira un niveau de dopage de quelques 10²⁰ at./cm³, ce qui correspond à une résistance de l'ordre de 10 ohms/carré.

Un avantage de la structure selon la présente invention est qu'elle est technologiquement plus simple à réaliser que la structure de la figure 2. En effet, il n'est pas nécessaire de prévoir de couches d'oxyde d'épaisseur bien déterminée pour former le diélectrique d'un condensateur de capacité déterminé ni de prévoir d'étape spécifique de formation de résistance.

Un autre avantage de la structure selon la présente invention est que la valeur de la capacité est ajustée simplement par le masque délimitant la zone de la région 31 située sous la métallisation M14.

Un autre avantage de la structure selon la présente invention est que sa surface peut être plus petite pour une valeur de capacité donnée que la structure de la figure 2. En effet, une capacité de jonction présente une valeur de l'ordre de 1500 pf/nm² alors qu'une capacité à diélectrique, pour une épaisseur d'oxyde de 100 nm, présentera seulement une capacité de l'ordre de 500 pf/mn². En pratique, il est difficile de descendre en dessous de 100 nm pour l'épaisseur de diélectrique dans des technologies classiques.

Bien entendu, la présente invention est susceptible de diverses variantes et modifications qui apparaîtront à l'homme de l'art. Par exemple, bien que le mode de réalisation des résistances comme constituées d'un certain nombre de "carrés" de la couche N 31 apparaisse aujourd'hui comme la plus simple, on pourra envisager de réaliser d'autres modes de réalisation de résistances, par exemple des résistances constituées de métallisations fines formées sur l'isolant ou de portions de silicium polycristallin. En ce cas, les zones de la région 31 sont situées sous chacune des métallisations et seront disjointes. D'autre part, on notera que l'on peut avec une structure diffusée unique, réaliser des résistances de valeur réglable en prévoyant de recouvrir d'une métallisation une partie au moins des portions 31-1 et 31-2.

## Revendications

1. Composant monolithique constituant une structure de protection contre des décharges électrostatiques et de filtrage comprenant, du côté de la face supérieure d'un substrat (30) d'un premier type de conductivité, une région (31) du type de conductivité opposé séparée en trois zones principales recouvertes de métallisations respectives (M12, M13, M14), la face arrière du composant étant revêtue d'une métallisation (M11), caractérisé en ce que l'une des zones principales est reliée à chacune des autres zones par une portion (31-1, 31-2) de ladite région du type de conductivité opposé (31) de surface réduite.

2. Composant monolithique selon la revendication 1, caractérisé en ce que les zones situées sous les première et deuxième métallisations (M12, M13) ont de mêmes surfaces.

3. Composant monolithique selon la revendication 1, caractérisé en ce que le substrat est une région de type P d'un niveau de dopage de l'ordre de 10¹⁸ atomes/cm³ et ladite région du type de conductivité opposé (31) est une région de type N d'un niveau de dopage de l'ordre de 10²⁰ atones/cm³.
